**Europäisches Patentamt**

**European Patent Office**

**Office européen des brevets**

(19)

(11) Veröffentlichungsnummer: **0 068 501**
**B1**

(12) # EUROPÄISCHE PATENTSCHRIFT

(45) Veröffentlichungstag der Patentschrift:
**16.10.85**

(21) Anmeldenummer: **82105789.0**

(22) Anmeldetag: **29.06.82**

(51) Int. Cl.⁴: **G 01 R 19/155**, G 01 R 19/14

(54) **Prüfeinrichtung zum Anzeigen einer elektrischen Spannung, deren Polarität und zur Durchgangsprüfung.**

(30) Priorität: **29.06.81 DE 3125552**
**14.04.82 DE 3213749**

(43) Veröffentlichungstag der Anmeldung:
**05.01.83 Patentblatt 83/1**

(45) Bekanntmachung des Hinweises auf die Patenterteilung:
**16.10.85 Patentblatt 85/42**

(84) Benannte Vertragsstaaten:
**AT BE CH DE FR GB IT LI NL SE**

(56) Entgegenhaltungen:
**EP - A - 0 011 711**
**DE - B - 2 317 743**
**FR - A - 2 388 281**
**FR - A - 2 441 851**
**US - A - 3 555 420**

**ETZ, Band 102, Nr. 14, 1981, Seite 747**

(73) Patentinhaber: **Siemens Aktiengesellschaft, Berlin und München Wittelsbacherplatz 2, D-8000 München 2 (DE)**

(72) Erfinder: **Koslar, Manfred, Dipl.-Ing., Schröderstrasse 16, D-4840 Rheda-Wiedenbrück (DE)**

## Beschreibung

Die Erfindung betrifft eine Prüfeinrichtung zum Anzeigen einer elektrischen Spannung, deren Polarität und zur Durchgangsprüfung, die aus zwei durch ein Kabel verbundenen, mit Kontaktspitzen versehenen und je einen den Kontaktspitzen nachgeschalteten hochohmigen Vorwiderstand enthaltenden Griffen besteht und einer dieser Griffe optische Anzeigeelemente von in Spannungsbereiche (z.B. 6, 12, 24, 50, 110, 220, 380, 660 V) gestaffelten Anzeigestufen, einen Oszillator, der einen gegebenenfalls vorhandenen akustischen Signalgeber ansteuern kann, und einen Trennverstärker enthält, der den durch die beiden Vorwiderstände begrenzten Eingangsstrom verstärkt, eine in der Prüfeinrichtung vorhandene Batterie in den Stromkreis einschaltet und damit die gestaffelte Anzeige der zu prüfenden Spannung und gegebenenfalls die Polaritätsanzeige sowie die Einschaltung des akustischen Signalgebers bewirkt.

Eine Prüfeinrichtung, die diese Merkmale aufweist, ist unter der Bezeichnung «Weidmüller U1T» im Handel erhältlich und im Prospekt der Fa. Weidmüller, der die Bezeichnung «U1T Sicherheit x 7» trägt, beschrieben. Dieser Prospekt wurde erstmalig auf der Hannover-Messe 1980 frei verteilt [vgl. auch Zeitschrift «etz» Bd. 102 (1981) Heft 14, Seite 747].

Die bekannte Prüfeinrichtung zeigt zu prüfende Spannungen in den oben angegebenen Spannungsbereichen, jedoch ohne 660 V, gestaffelt an. Die in den beiden Griffen vorhandenen und den Kontaktspitzen nachgeschalteten Vorwiderstände haben je einen Widerstand von 5 MOhm, also zusammen 10 MOhm. Prüfstrom der anzuzeigenden Spannung und Anzeigestrom sind voneinander durch einen Trennverstärker getrennt, dem der durch die zu prüfende Spannung erzeugte und durch die beiden Vorwiderstände begrenzte Strom zugeführt wird. Der Anzeigestrom, der die jeweiligen Anzeigestufen speist, wird von der in der Prüfeinrichtung vorhandenen Batterie (12 V) geliefert und durch im Trennverstärkerteil vorhandene Transistoren eingeschaltet.

Die bekannte Prüfeinrichtung enthält einen Signalgeber, der in der älteren EP-A1-0 038 043, veröffentlicht am 21. 10. 1981 (vgl. DE-A1-3 013 788), beschrieben ist. Der Signalgeber (Buzzer) besteht aus einer piezoelektrischen Keramikscheibe mit drei Elektroden. An die Erreger-Elektroden wird die Steuerspannung gelegt, und an der dritten Elektrode (Rückkopplungselektrode) wird das erzeugte Signal akustisch ausgekoppelt und über einen Widerstand an den Eingang eines Verstärkers gegeben. Es handelt sich somit um einen elektro-akustisch rückgekoppelten Tonsignal-Generator, dessen Grundfrequenz durch die Schwingparameter der piezoelektrischen Keramikscheibe bestimmt wird. Eine mit dem Signalgeber verbundene Spule dient der Spannungsüberhöhung zur Steigerung der Lautstärke.

Bei der bekannten Prüfeinrichtung sind die einzelnen Anzeigestufen dreifach unterteilt. Die Anzeigestufen, die eine zu prüfende Spannung von 6 V bis kleiner 12 V anzeigen, dienen gleichzeitig zur Anzeige der Polarität bei Gleichspannung. Bei anliegender Wechselspannung leuchtet sowohl die Leuchtdiode für negative als auch die Leuchtdiode für positive Polarität auf.

Die Anzeigestufen für Spannungsbereiche von 12 V bis kleiner 24 V, 24 V bis kleiner 50 V und 50 V bis kleiner 110 V stellen zusammengeschaltet eine Anzeigekette dar, während die Anzeigestufen für Spannungsbereiche von 110 V bis kleiner 220 V, 220 V bis kleiner 380 V und gleich bzw. grösser als 380 V zusammengeschaltet ebenfalls eine Anzeigekette darstellen.

Innerhalb dieser Anzeigeketten sind Spannungsteiler, Transistoren und Leuchtdioden miteinander in der Weise verschaltet, wie es in der bekannten Prüfeinrichtung der EP-A1 0 011 711 (entsprechend DE-C3 2 846 675 und US-A1 4 301 407) beschrieben ist. Dabei sind die einzelnen Teilerpunkte des aus Widerständen bestehenden Messteilers jeweils mit der Basis des jeder Anzeigestufe zugeordneten Transistors verbunden, während die Emitter dieser Transistoren über die als Leuchtdioden ausgeführten nichtlinearen Anzeigeelemente so verbunden sind, dass die Transistoren untereinander gestaffelt jeweils als nichtlinear arbeitende Differenzverstärker wirken, indem die Emitter jeweils zweier aufeinanderfolgender Transistoren über das Anzeigeelement verbunden sind, und die Kollektoren der Transistoren untereinander verbunden sind und zu einer gemeinsamen Spannungsversorgung führen.

Die eingangs genannte bekannte Prüfeinrichtung weist einen Tastschalter auf, bei dessen Ruhestellung die Prüfeinrichtung zur Spannungsprüfung dient. Beim Umschalten dieses Tastschalters wird die in einem Gehäuse gemäss DE-C3 2 756 830 (vergl. auch US-A 4 210 862, Fig. 6 und 7) untergebrachte Batterie eingeschaltet, so dass ein zwischen den Kontaktspitzen befindlicher Leiter auf Stromdurchgang überprüft werden kann. Bei direktem Kontakt der beiden Prüfspitzen werden die Funktionen der Prüfeinrichtung, nämlich die Funktionsfähigkeit der Batterie und ihre Spannung (sie sollte 12 V betragen), des Signalgebers und der Anzeigeelemente für die Polaritätsanzeige, überprüft. Weitere Eigenprüfungen sind mit der bekannten Prüfeinrichtung nicht möglich.

An eine Prüfeinrichtung der eingangs angegebenen Art, also einer zweipoligen und hochohmigen Prüfeinrichtung, sind in erster Linie aus Gründen der Sicherheit für die mit der Prüfeinrichtung arbeitende Person, aber auch aus Gründen der eindeutigen Anzeige und der praktischen Handhabung mehrere Forderungen zu stellen; diese sind:

1. Der Innenwiderstand der Prüfeinrichtung muss mindestens so hoch sein (grösser als 500 kOhm), dass die Prüfperson selbst beim Berühren einer Kontaktspitze noch ausreichend geschützt ist; Prüfeinrichtungen mit einem Widerstand von 500 kOhm und mehr haben den Vorteil, dass bei einer Wechselspannung von 220 V gegen Erde eine Kontaktspitze ohne Gefahr für die Prüfperson berührt werden kann, wenn die andere Kontaktspitze sich an Spannung befindet (Berührsicherheit);

2. die die Hochohmigkeit bewirkenden Vorwiderstände reduzieren den Prüfstrom, dennoch soll eine eindeutig helle Anzeige für das Vorhandensein einer Spannung stattfinden; der hohe Eingangswiderstand einer solchen Prüfeinrichtung gewährleistet, dass keine wesentlichen Messverfälschungen bei hochohmigen Spannungsquellen vorliegen, und er gewährleistet darüberhinaus, wie unter Punkt 1 angegeben, die Berührsicherheit;

3. die Hochohmigkeit der Prüfeinrichtung erfordert, dass für die Anzeigeelemente eine gesonderte Spannungsquelle vorhanden ist, d.h. dass Prüfstrom und Anzeigestrom voneinander getrennt sein müssen;

4. der hochohmige Eingangswiderstand gewährleistet, gegebenenfalls zusammen mit spitzenspannungsfesten Widerständen, dass bei auftretenden Spannungsspitzen im Netz kein Überschlag und damit keine Zerstörung des Spannungsprüfers mit Gefahr für die Prüfperson erfolgen kann (Spitzenspannungsfestigkeit);

5. hochohmige Vorwiderstände, die sowohl im die Anzeigeelemente enthaltenden Griff als auch im anderen Griff der zweipoligen Prüfeinrichtung vorhanden sind, sollen sicherstellen, dass selbst bei Verletzung des die beiden Griffe verbindenden Kabels, z.B. durch zufälliges Durchschneiden bzw. Durchscheuern des Kabels, die Sicherheit für die Prüfperson gewährleistet ist (Trennung des Eingangswiderstandes in zwei Vorwiderstände);

6. die Prüfeinrichtung soll sowohl eine optische als auch eine akustische Indikation aufweisen, um Fehlschlüsse mit doppelter Sicherheit auszuschliessen, wofür die optische Anzeige genügend hell und die akustische Indikation genügend laut sein müssen;

7. die Prüfeinrichtung muss gegenüber jeder denkbaren Fehlbedienung sicher sein; eine solche Fehlbedienung liegt vor, wenn gemäss Forderung 1 eine der Kontaktspitzen sich an hoher Spannung befindet und die andere Kontaktspitze von der Prüfperson berührt wird, gegen diese Fehlbedienung ist die Prüfeinrichtung hochohmig ausgestattet. Ferner kann eine Fehlbedienung vorliegen, wenn bei an den Kontaktspitzen anliegender hoher Spannung (z.B. Netzspannung) der Schalter für die Durchgangsprüfung bzw. zum Eigentest betätigt wird, in einem solchen Fall darf nicht nur keine Gefahr für Gerät und Benutzer bestehen, sondern darüberhinaus muss die anliegende Klemmspannung eindeutig angezeigt werden;

8. eine batteriebetriebene Prüfeinrichtung muss auf die Funktionsfähigkeit der Batterie testbar sein und hierfür einen Eigen-Batterietest enthalten;

9. neben diesem Eigen-Batterietest muss eine Prüfeinrichtung der hier in Rede stehenden Art eine Durchgangsprüfung von Spitze zu Spitze gewährleisten, wobei die Anzeigeelemente für die Polaritätsprüfung und für die unteren Spannungsbereiche zur Anzeige der Batteriespannung geprüft werden;

10. die Prüfeinrichtung muss sich selbst einschalten, damit eine Anzeigefehldeutung, die bei erforderlicher Einschaltung durch den Benutzer auftreten könnte, ausgeschlossen ist;

11. ein völliger Funktionstest soll ermöglichen, dass vor oder während der Spannungsprüfung die Funktion einer jeden einzelnen Anzeigestufe eindeutig geprüft werden kann;

12. es muss gewährleistet sein, dass der Funktionstest nicht nur die Anzeigefunktionen (optische Stufenanzeige und akustische Indikation) zu überprüfen gestattet, sondern dass auch das beide Prüfgriffe verbindende Kabel, der zweite Prüfgriff und die Prüfspitzen auf funktionsgerechtes Arbeiten hin überprüft werden und dass der Funktionstest zweifelsfrei nur dann als vollständig erkannt werden kann, wenn beide Bedingungen erfüllt sind;

13. oberhalb des Spannungsbereiches für 380 V soll noch ein weiterer Spannungsbereich (z.B. 660 V) angezeigt werden (um ohne Gefahr an Fremdnetzen arbeiten zu können, z.B. auf Schiffen).

14. Die Prüfeinrichtung soll es auch ermöglichen, dass der hohe (≥600 kOhm) Eingangswiderstand vorübergehend erniedrigt werden kann.

Aus der GB-A 1 562 578, bzw. aus der US-A 4 210 862, die beide auf mehrere deutsche Prioritätsanmeldungen zurückgehen, von denen hier die der DE-C3 2 734 833 zugrundeliegende Prioritätsanmeldung relevant ist, ist bekannt, bei einer niederohmigen Prüfeinrichtung für Spannungs- und Durchgangsprüfung dem Tastschalter, der bei Ruhestellung die Spannungsprüfung und bei Arbeitsstellung die Durchgangsprüfung ermöglicht, eine Zenerdiode parallel zu schalten, was im vorliegenden Zusammenhang dem Teil der Forderung 7 des obigen Kataloges an Forderungen genügen würde, der sich mit Fehlbedienung des Tastschalters bei anliegender Klemmspannung befasst.

Einige dieser Forderungen (1, 2, 3, 4, 8, 9, 10) werden auch durch eine Prüfeinrichtung in Form eines Schraubendrehers erfüllt, die in der DE-C2 3 004 734 beschrieben ist; diese Prüfeinrichtung ist allerdings einpolig, für eine gestaffelte Anzeige sowie auch zur Erfüllung weiterer Forderungen nicht geeignet.

Die oben ausführlich beschriebene und zum Stand der Technik gehörende Prüfeinrichtung erfüllt nur die Forderungen 1 bis 10 des Forderungskatalogs. Die Zuschaltung einer weiteren Anzeigestufe für einen noch höheren Spannungsbereich (Forderung 13) ist bei den in dieser bekannten Prüfeinrichtung vorliegenden Gegebenheiten nicht möglich, und zur Erfüllung der Forderungen Nr. 11, 12 und 14 ist die bekannte Prüfeinrichtung nicht geeignet.

Der vorliegenden Erfindung liegt die Aufgabe zugrunde, eine Prüfeinrichtung der eingangs angegebenen Art derart weiterzubilden, dass sämtliche Forderungen des Forderungskatalogs erfüllt werden.

Zur Lösung dieser Aufgabe ist die Prüfeinrichtung erfindungsgemäss durch folgende Merkmale gekennzeichnet:

a) es ist ein Schaltnetzteil vorhanden, das durch den Oszillator gespeist wird und zur Überhöhung der Batterie-Spannung dient,

b) es ist ein Energiespeicher vorhanden, insbesondere in Form eines Kondensators, der durch die Ausgangsspannung des Schaltnetzteiles gespeist wird, solange ein zwischengeschaltetes Schaltelement sich in Ruhestellung befindet,

c) das bei der Aufladung des Energiespeichers in Ruhestellung befindliche Schaltelement ist umschaltbar, um die im Energiespeicher befindliche Ladung auf den Eingang des Trennverstärkers zu legen und damit die Funktionsfähigkeit sämtlicher Anzeigefunktionen der Prüfeinrichtung der Reihe nach selbsttätig zu überprüfen,

d) der Oszillator ist mit der Basis von Transistoren verbunden, die den Anzeigestrom für die Anzeigeelemente sowohl für zu prüfende Spannungen in oberen Spannungsbereichen (gleich oder grösser 110 V) als auch für die Anzeigeelemente für zu prüfende Spannungen unterer Spannungsbereiche (grösser 6 und kleiner 110 V) kurzzeitig intermittierend einschalten (choppen),

e) es ist ein Schaltelement vorhanden, das in Ruhestellung eine Zenerdiode überbrückt und bei dessen Umschaltung auf den Arbeitskontakt durch Einschalten der Batterie die Durchgangsprüfung durch einen zwischen den Kontaktspitzen befindlichen Leiter oder beim unmittelbaren Kontakt zwischen den Kontaktspitzen der Eigentest der Prüfeinrichtung auf Funktionsfähigkeit der Batterie, des Signalgebers, sämtlicher elektrischer Verbindungselemente zwischen den Prüfspitzen der Anzeigeelemente für die Polaritätsanzeige und, je nach Batteriespannung des zugehörigen weiteren Anzeigeelementes sowie vor allem die Aufladung des Kondensators im Energiespeicher erfolgt.

Eine bevorzugte Ausführungsform der Prüfeinrichtung ist durch folgende Merkmale gekennzeichnet:

a) dem als Eingangsstufe dienenden Trennverstärker sind die beiden hochohmigen, spannungsfesten Vorwiderstände vorgeschaltet, von denen einer im Griff und der andere, getrennt über das mit der Abschirmung versehene Kabel, im anderen Griff untergebracht sind, wobei diese beiden Vorwiderstände den durch die zu prüfende Spannung erzeugten Strom begrenzen, der dem Trennverstärker, enthaltend die Emitterfolger und die Eingangsteiler, zugeführt wird, so dass die Transistoren je nach anliegender Polarität der zu prüfenden Spannung über einen Graetz-Gleichrichter, der aus diesen Transistoren und zwei Zenerdioden gebildet ist, leitend werden und damit je nach Anliegen der Polarität über die Transistoren entweder die Leuchtdiode für die Anzeige der positiven Eingangsspannung oder die Leuchtdiode für die Anzeige der negativen Eingangsspannung oder bei Wechselspannung beide Leuchtdioden angesteuert und durchgeschaltet werden und gleichzeitig, indem die Transistoren durchschalten, die Basis des Transistors eine Potentialdifferenz zum positiven Potential der Batterie erhält und der Strom zum Aufleuchten der Anzeigeelemente, eingeschaltet durch diesen Transistor, fliessen kann;

b) der Oszillator besteht aus einer Zusammenschaltung eines Transistors, Widerständen, einer Induktivität und dem Signalgeber, der in an sich bekannter Weise aus einem piezokeramischen Schwinger mit drei Elektroden besteht und durch den Oszillator-Transistor über die Widerstände eingeschaltet wird;

c) das Schaltnetzteil besteht aus einer Spannungsverdopplerschaltung (nach Villard), gebildet aus drei Dioden, einer Zenerdiode und drei Kondensatoren, einem Koppelkondensator und der zugeschalteten Induktivität und dem schaltenden Oszillator der Impulsspannungsquelle;

d) der Energiespeicher besteht aus einem Speicherkondensator, einer der Spitzengleichrichtung dienenden Diode und einem Schaltelement, über dessen Ruhestellung Speicherkondensator und Diode miteinander verbunden sind, wobei die Spannungsimpulse aus dem Schaltnetzteil durch die Spitzengleichrichtung im Speicherkondensator gespeichert werden, so dass dieser sich auf den Scheitelwert der Spannungsimpulse auflädt;

e) in der Verbindung zwischen dem Arbeitskontakt des Schalters und dem Eingang zum Trennverstärker befindet sich eine Schutzdiode mit Strombegrenzungswiderstand.

Eine weitere bevorzugte Ausführungsform der Prüfeinrichtung ist erfindungsgemäss dadurch gekennzeichnet, dass die Anzeigestufen für die gestaffelte Anzeige der einzelnen Spannungsbereiche in zwei Anzeigeketten geteilt ist, die getrennt voneinander mit dem Anzeigestrom versorgt werden, dass eine Anzeigekette für untere Spannungsbereiche aus der Batterie über den Schalttransistor gespeist wird, dass die andere Anzeigekette für obere Spannungsbereiche aus dem Schaltnetzteil gespeist wird und dass beide Anzeigeketten zur Stromeinsparung mit der Frequenz des Oszillators intermittierend geschaltet (gechoppt) werden.

Neben allen mit der bekannten Prüfeinrichtung erreichbaren Vorteilen wird durch die Prüfeinrichtung der vorliegenden Erfindung erreicht, dass auch oberhalb 380 V ein weiterer Spannungsbereich (üblich und in der Industrie vorkommend sind hier 660 V zu nennen) angezeigt werden kann. Ferner werden als besonderer Vorteil bei der Prüfeinrichtung der vorliegenden Erfindung die Forderungen 11 und 12 des Forderungs-Katalogs erfüllt, indem mit dem zusätzlichen Funktionstest alle Anzeigestufen der gestaffelten Spannungsbereichsanzeige jeweils geprüft werden können, und zwar sowohl nach dem Eigen-Batterietest als auch während der Spannungsprüfung. Wenn somit nach der Überprüfung sämtlicher Anzeigestufen im Funktionstest ein Defekt in der Prüfeinrichtung oder zumindest in einer Anzeigestufe auftritt, so kann dieser Effekt noch während der Spannungsprüfung entdeckt werden. Als Beispiel sei angeführt, dass eine Prüfperson mit der Prüfeinrichtung feststellt, dass eine Spannungsquelle 220 V aufweist, weil sämtliche Anzeigeelemente für diese Spannung aufleuchten, nicht aber die Anzeigeelemente für 380 oder 660 V. Um sicher zu gehen, dass nicht doch 380 oder 660 V vorliegen, kann die Prüfperson den Schalter S2 betätigen, wodurch sich der Energiespeicher entlädt und, über den Trennverstärker verstärkt, auch die Anzeigeelemente der Anzeigestufen für die Spannungsbereiche 660 V und 380 V aufleuchten müssen. Leuchtet dabei eines der beiden Anzeigeelemente der oberen Spannungsbereiche nicht auf, dann ist die zugehörige Anzeigestufe defekt. Leuchten beide Anzeigeelemente nicht auf, dann sind beide Anzeigestufen defekt. Leuchten aber beide Anzeigeelemente auf und verlöschen entsprechend der Entladung des Energiespeichers wieder, so kann die Prüfperson sicher sein, dass die anliegende Spannung zutreffend angezeigt wird.

Mit diesem zusätzlichen Funktionstest kann somit die Prüfeinrichtung – zusammen mit einer einfach gehaltenen Beschreibung – sogar einem sich auf diesem Gebiet betätigenden Laien ohne weiteres in die Hand gegeben werden, denn alle denkbaren Bedienungsfehler und alle denkbaren Fehldeutungen der Anzeige sind ausgeschlossen.

Ferner soll durch die Prüfeinrichtung der Erfindung beim Prüfen einer Spannung unterschieden werden können, ob die Spannungsquelle niederohmig oder hochohmig ist. Prüfeinrichtungen müssen, wie allgemein Spannungsmessgeräte, aus messtechnischen Gründen, aber auch aus Gründen, die die Sicherheit betreffen, einen relativ hohen Eingangswiderstand aufweisen.

Der hohe Eingangswiderstand, der vorzugsweise etwa in der Grössenordnung von 1 MOhm liegt, z.B. $\geq$600 kOhm, ist erforderlich, um Spannungsquellen mit hochohmigem Innenwiderstand nicht zu sehr zu verfälschen und um bei Überspannungen aus Sicherheitsgründen eine genügend hohe Spannungsfestigkeit der hier in Rede stehenden Prüfeinrichtungen zu gewährleisten.

Bei einem Eingangswiderstand beispielsweise von etwa 600 bzw. 660 kOhm beträgt der Eingangsstrom bei

| 110 | 220 | 380 | 660 | $(V_{eff})$ |
|------|------|------|---|----------------|
| 0,17 | 0,33 | 0,58 | 1 | $(mA_{eff})$. |

Damit ist der Eingangsstrom selbst bei kritischem Massstab auch dann nicht gefährlich, wenn versehentlich eine der Kontaktspitzen vom Benutzer berührt wird, während die andere Kontaktspitze an hoher Spannung liegt.

Andererseits werden die hier in Rede stehenden Prüfeinrichtungen auch zur Prüfung beispielsweise von Schaltschränken und zur Prüfung der Verkabelung von grösseren Anlagen benutzt. Dies führt in der Praxis zu Schwierigkeiten, weil diese Prüfeinrichtungen wegen des hohen Eingangswiderstandes zu empfindlich sind und weil kapazitiv oder induktiv einstreuende Fremdspannungen auch auf nicht angeschlossenen oder nicht geschalteten Kabeln (leerlaufende Leitungen) von der Prüfeinrichtung angezeigt werden.

Für diese angegebenen Zwecke ist es aus den angegebenen Gründen erforderlich, sog. niederohmige Spannungsprüfeinrichtungen zu verwenden. Systemmässig betrachtet führt dies jedoch zu der Forderung, dass Spannungsprüfeinrichtungen zwar hochohmig sein müssen (messtechnische Gründe, Sicherheitsgründe), dass aber wahlweise ein sog. Lastwiderstand zur Verringerung des Eingangswiderstandes wahlweise zuschaltbar ist.

Die vorliegende Erfindung befasst sich deshalb auch mit diesem Problem und hat sich im Rahmen der oben genannten Aufgabe ferner zur Aufgabe gestellt, eine Schaltungsanordnung zur Erniedrigung des Eingangswiderstandes einer wie einleitend beschriebenen Prüfeinrichtung anzugeben, bei der es möglich ist, die ohmsche Last zeitlich zu begrenzen, und zwar so, dass sie ohne Zutun des Benutzers bei Überschreitung einer gewissen Energiemenge abgeschaltet wird, wobei jedoch die Zeit so bemessen ist, dass sie dem Benutzer die Möglichkeit gibt, den Belastungstest und seine Auswirkungen auf das Prüfergebnis auch noch erkennen zu können.

Hierzu ist die Prüfeinrichtung der eingangs angegebenen Art erfindungsgemäss somit ferner dadurch gekennzeichnet, dass der Gesamtschaltung im Griff der Prüfeinrichtung und den den hohen Eingangswiderstand ergebenden, in beiden Griffen untergebrachten Widerständen wenigstens ein PCT-Widerstand mit einem Nennwiderstand $R_N$ im Bereich zwischen 200 Ohm und 5 kOhm wahlweise einschaltbar parallel geschaltet ist, der eine Zeitkonstante der Eigenerwärmung (Betriebsabschaltzeit $t_{aB}$) von wenigstens 1 Sekunde gewährleistet.

Bevorzugte Ausführungsformen davon sind durch die Merkmale der abhängigen Ansprüche 6, 7 und 8 gekennzeichnet.

Hierdurch wird das Problem gelöst, dass Spannungsprüfeinrichtungen mit hohem Eingangswiderstand wahlweise, beispielsweise durch einen Tastschalter, ein Widerstand etwa im Bereich von 2 bis 10 kOhm parallel eingeschaltet werden kann.

Aufgrund einer Leistungsbetrachtung führt das Problem zu einem gewissen Widerspruch, denn ist z.B. die höchste auf der Spannungsprüfeinrichtung angegebene Spannung 500 V, so würde eine Zuschaltung eines Widerstandes von 4 kOhm in der Spannungsprüfeinrichtung eine Leistung von 63 W freisetzen. Die dadurch be-

dingte Erwärmung der Prüfeinrichtung, d.h. des Griffes, in der die Schaltung enthalten ist, wäre unvermeidlich, so dass dieser Weg keine Lösung der Aufgabe darstellt.

Man könnte diese hohe Belastung beispielsweise durch Blindwiderstände realisieren, indem man Spulen oder Kondensatoren einschaltet. Gemäss den VDE-Vorschriften ist aber die Verwendung von solchen Blindwiderständen aus Sicherheitsgründen nicht gestattet. Die Einführung von reinen ohmschen Widerständen hätte den aufgezeigten Widerspruch nicht gelöst.

Durch die hier vorgeschlagene Verwendung eines PTC-Widerstandes, der durch die Eigenerwärmung nach einer bestimmten Zeit selbstregelnd seinen Widerstand zu höheren Werten hin verändert, um somit den Strom zurückzuregeln und damit die Leistung zu begrenzen, war es möglich, die der Erfindung zugrundeliegende Aufgabe zu lösen und die sich ergebenden Widersprüche in der Problemstellung zu beseitigen.

Hinsichtlich der Definition von PTC-Widerständen wird auf die deutsche Norm DIN 44 080, Dez. 1976, verwiesen. In dieser Vorschrift ist im einzelnen definiert, was unter einem PTC-Widerstand (Kaltleiter) zu verstehen ist und wie die einzelnen Angaben der Eigenschaften, beispielsweise Nennwiderstandswert $R_N$ und Betriebsabschaltzeit $t_{aB}$ definiert sind.

Um die Zeitkonstante des Erwärmungsvorgangs beeinflussen zu können, ist es vorteilhaft, dem PTC-Widerstand einen normalen ohmschen Widerstand, d.h. ein Widerstand mit praktisch festem Widerstandswert, in Reihe zu schalten. Auf diese Weise wird erreicht, dass in dem Moment des Einschaltens die Leistung an dem PTC-Widerstand und an dem zugehörigen Vorwiderstand so aufgeteilt wird, dass es einer gewissen Zeit bedarf, bis der PTC-Widerstand soweit erwärmt ist, dass er hochohmig wird und damit den Strom zurückregelt.

Die Zeitkonstante des Erwärmungsvorgangs kann durch das Volumen des PTC-Widerstandes beeinflusst werden. Ein solcher PTC-Widerstand muss verhältnismässig gross sein und würde bei einem Durchmesser von 10 mm eine Dicke von 20 mm haben.

Die im Handel befindlichen PTC-Widerstände, die durch ihr kleines Volumen (z.B. Durchmesser 5 mm, Dicke 1 mm) sind wesentlich preisgünstiger und hinsichtlich der Konstanz ihrer Werte genauer, jedoch würden solche PTC-Widerstände zu schnell (in wenigen Millisekunden) hochohmig werden, so dass dem Benutzer keine Zeit verbleibt, ein eindeutiges Ergebnis des Testes dahingehend abzulesen, ob es sich um eine Spannungsquelle mit hohem oder mit niedrigem Innenwiderstand handelt. Durch den gemäss einer vorteilhaften Weiterbildung der Erfindung in Reihe mit dem PTC-Widerstand geschalteten Widerstand mit praktisch festem Widerstandswert (Vorwiderstand) gelingt es aber, die Zeitkonstante des Erwärmungsvorgangs so zu beeinflussen, dass für den Benutzer mehrere Sekunden verbleiben, um das Ergebnis des Tests ablesen zu können.

Eine weitere Verminderung des Lastwiderstandes, der aus dem PTC-Widerstand allein oder einem PTC-Widerstand mit in Reihe geschaltetem Vorwiderstand resultiert, lässt sich durch Parallelschaltung solcher Systeme erreichen, die selbst aus einer Reihenschaltung eines PTC-Widerstandes mit einem normalen Widerstand bestehen.

Bei einer bevorzugten Ausführungsform der Erfindung ist bei einem Eingangswiderstand der Prüfeinrichtung von etwa 600 bzw. 660 kOhm wenigstens ein PTC-Widerstand wahlweise zuschaltbar, der einen Nennwiderstandswert $R_N$ von 1,5 kOhm ergibt. In diesem Fall ist es vorteilhaft, dass der wenigstens eine mit dem PTC-Widerstand in Reihe geschaltete Festwiderstand einen Widerstandswert von 12 kOhm ergibt.

Die Erfindung wird nachfolgend anhand der beigefügten Zeichnungen näher erläutert.

Es zeigen:

Fig. 1 eine Gesamtansicht der Prüfeinrichtung etwa im Massstab 1:1,

Fig. 2 ein Blockschaltbild für das Prinzip der Wirkungsweise der Prüfeinrichtung,

Fig. 3 ein Gesamtschaltbild einer bevorzugten Ausführungsform der Prüfeinrichtung,

Fig. 4 einen Ausschnitt der Schaltung gemäss Fig. 3 und

Fig. 5 eine Teilschaltung für Fig. 4,

Fig. 6 die Schaltungsanordnung zur vorübergehenden Erniedrigung des Eingangswiderstandes und

Fig. 7 ein Diagramm des Belastungsstromes in Abhängigkeit von der anliegenden Spannung bei vorübergehend erniedrigtem Eingangswiderstand.

In den Figuren sind gleiche oder einander entsprechende Teile mit gleichen Bezugszeichen versehen.

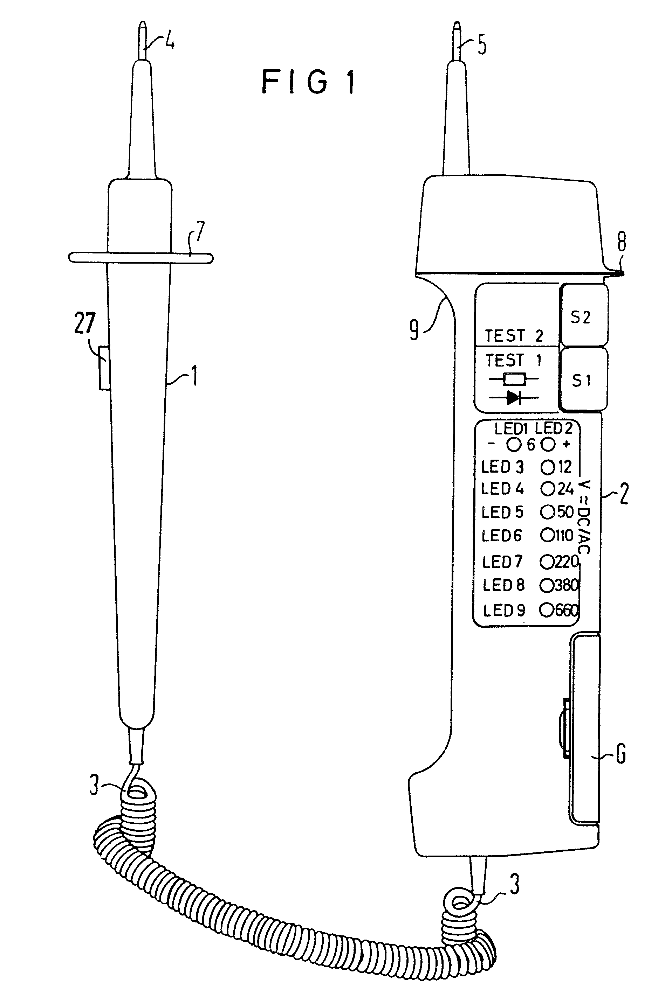

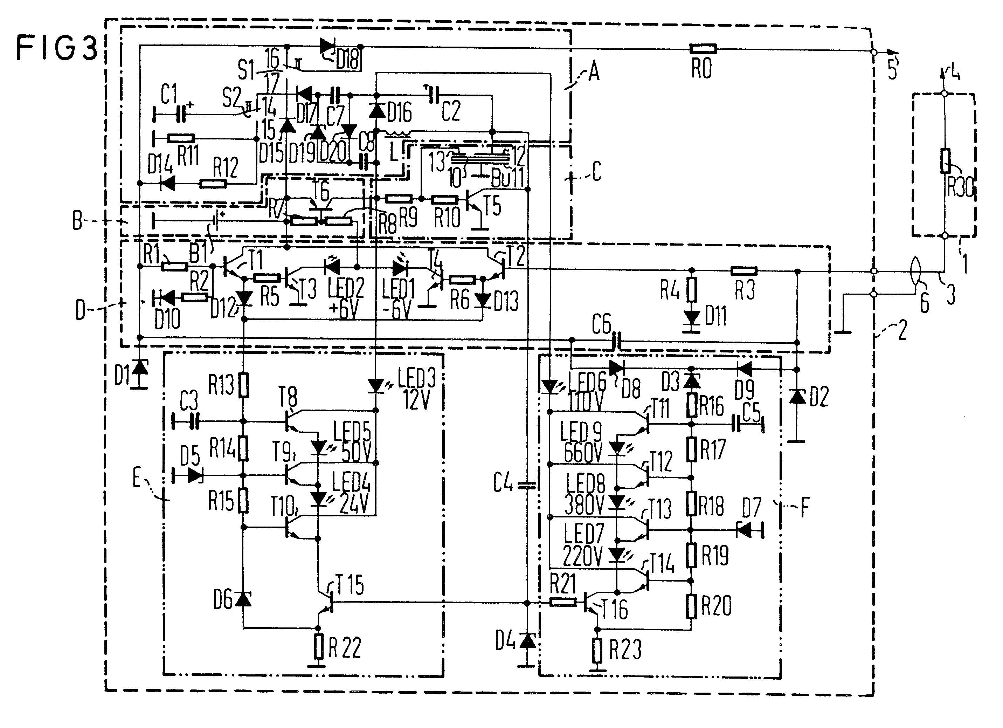

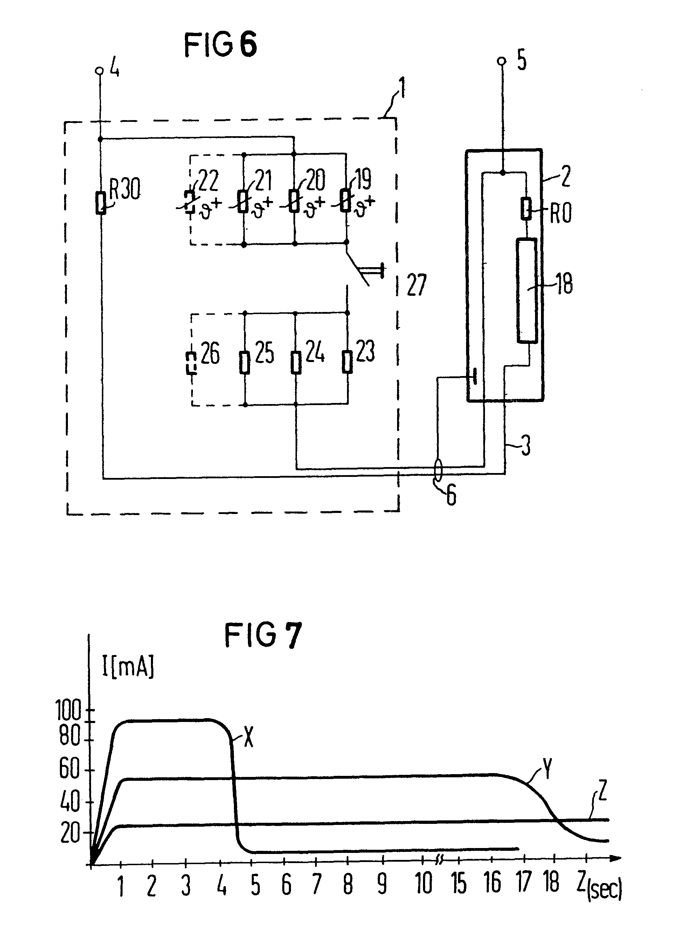

Fig. 1 zeigt den Griff 1, der mit dem Griff 2 durch ein Kabel 3 verbunden ist. Der Griff 1 ist mit der Kontaktspitze 4 und der Griff 2 ist mit der Kontaktspitze 5 versehen. In Fig. 3 sind die Griffe 1 und 2 durch gestrichelt umrandete Felder dargestellt. Das Kabel 3 ist mit einer Abschirmung 6 (siehe Fig. 3 oder 4) versehen.

Während der Griff 1 lediglich die Kontaktspitze 4 trägt und in seinem Inneren den der Kontaktspitze 4 nachgeschalteten hochohmigen spannungsfesten Vorwiderstand R30 enthält, er wird nachfolgend als Prüfgriff 1 bezeichnet, enthält der mit der Kontaktspitze 5 versehene Griff 2 in seinem Inneren die gesamte Schaltung 18 und ist mit den Anzeigeelementen LED1 bis LED9 und zwei Tasten der Schalter S1 und S2 versehen. Dieser Griff wird nachfolgend als Anzeigegriff 2 bezeichnet. Er enthält ausserdem das Gehäuse G, in welchem die Batterie B1 untergebracht ist. Das Gehäuse G ist in der DE-C3 2 756 830 (s. auch US-A 4 210 862) beschrieben.

Sowohl der Prüfgriff 1 als auch der Anzeigegriff 2 sind entsprechend den einschlägigen Vorschriften für solche Prüfgeräte mit Abrutschringen 7 und 8 versehen. Diese Abrutschringe sollen vermeiden, dass der Benutzer der Prüfeinrichtung mit den Kontakten der Spannungsquelle in Berührung kommt. Die Vertiefung 9 im Anzeigegriff 2 dient dazu, dass dieser Griff vom Benutzer gut und sicher gehalten werden kann.

Die Tasten der Schaltelemente S1 und S2 sind so angeordnet, dass sie beim Umfassen des Anzeigegriffes 2 mit der rechten Hand durch den Daumen betätigt werden können; gleichzeitig sind die Anzeigeelemente LED1 bis LED9 auf der Fläche des Anzeigegriffes 2 derart angeordnet, dass sie durch Finger oder Handballen nicht verdeckt werden.

Der Anzeigegriff 2 ist in Fig. 1 als Draufsicht auf seine Breitseite gezeigt. Der Anzeigegriff 2 ist flach, d.h. seine Dicke beträgt nur etwa ein Drittel seiner Breite.

Der Griff 1 kann nicht nur als runder Stab (Fig. 1) ausgebildet sein, sondern der Griff 1 kann auch die gleiche äussere Form haben, wie der Griff 2, insbesondere wenn im Griff 1 die Bauelemente gemäss der Schaltung nach Fig. 6 untergebracht sind.

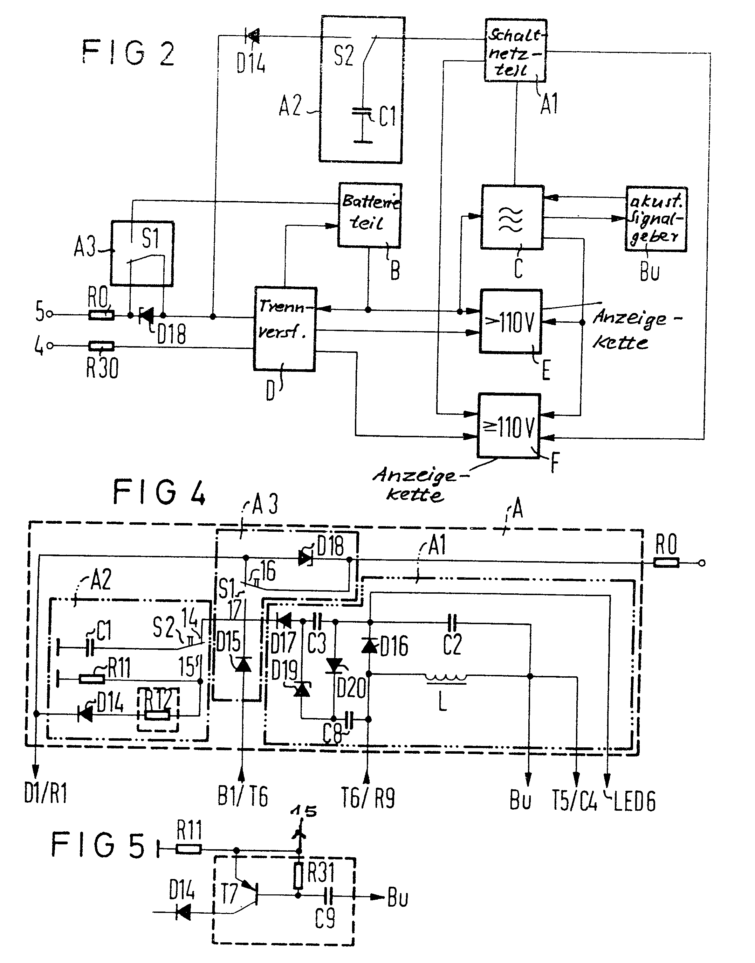

Im Blockschaltbild gemäss Fig. 2 ist gezeigt, dass die den Eingang bildenden Kontaktspitzen 4 und 5 jeweils über einen hochohmigen Vorwiderstand R30 und R 0 mit dem Trennverstärker D ist die Polaritätsanzeige integriert, die gleichzeitig die Anzeigestufen für den untersten Spannungsbereich darstellt.

Der durch die hohen Vorwiderstände R30 und R 0 reduzierte Strom, der von der zu prüfenden Spannungsquelle erzeugt wird, wird im Trennverstärker D verstärkt, und es wird bewirkt, dass der zur Versorgung der einzelnen Anzeigestufen notwendige Anzeigestrom, der von der Batterie B1 (Fig. 3) geliefert wird, eingeschaltet wird, d.h. es wird der mit der Einschaltung versehene Batterieteil B angesteuert. Ferner werden die einzelnen Anzeigestufen E und F und der Oszillator C angesteuert, der gegebenenfalls mit einem akustischen Signalgeber Bu verbunden ist. Der Oszillator C speist das Schaltnetzteil A1, das zur Überhöhung der Spannung dient. Vom Schaltnetzteil A1 wird der Energiespeicher A2 gespeist, solange ein zwischengeschaltetes Schaltelement S2 sich in Ruhestellung befindet, wie dies in Fig. 2 dargestellt ist.

Wird das bei der Aufladung des Energiespeichers A2 in Ruhestellung befindliche Schaltelement S2 umgeschaltet, so wird die im Energiespeicher A2 befindliche Ladung über den Vorwiderstand R12 und die Diode D14 auf den Eingang des Trennverstärkers D gelegt. Diese Spannung simuliert zu Beginn der Entladung eine an den Kontaktspitzen 4 und 5 anliegende Spannung, die grösser als die grösste durch die Prüfeinrichtung anzeigbare Spannung ist, so dass entsprechend der Entladung des Kondensators C1 alle Anzeigestufen angesteuert werden und damit alle Anzeigeelemente aufleuchten und der Reihe nach verlöschen.

Der Schaltungsteil A3, der ein hier in Ruhestellung gezeigtes Schaltelement S1 enthält und zu dem die Zenerdiode D18 gehört, dient zum Einschalten der Batterie B1 und damit zur Umschaltung der Prüfeinrichtung auf Durchgangsprüfung, wenn sich zwischen den Kontaktspitzen 4 und 5 ein Medium befindet, das auf Leitfähigkeit zu überprüfen ist. Wenn die Kontaktspitzen 4 und 5 direkt kurzgeschlossen werden, so erfolgt ein Eigentest der Prüfeinrichtung auf Funktionsfähigkeit der Batterie B1, des Signalgebers Bu, der Anzeigeelemente für die Polaritätsanzeige und, je nach Batteriespannung, eines ihr zugehörigen Anzeigeelementes der Anzeigekette E. Über den Trennverstärker D und den gesamten Ablauf der Schaltung wird dabei auch der Energiespeicher A2 aufgeladen, so dass bei Umschalten des Schaltelementes S1 von Arbeitsstellung auf Ruhestellung und Umschalten des Schaltelementes S2 von Ruhestellung auf Arbeitsstellung wiederum die Funktionsfähigkeit sämtlicher Anzeigestufen entsprechend der Entladung des Kondensators C1 erfolgt. Wichtig für den funktionell unbedingt erforderlichen Ablauf des kompletten Funktionstestes ist, dass die vollständige Prüfung aus zwei Schritten besteht. Gemäss Forderungskatalog ist der Funktionstest dann und nur dann eindeutig, wenn nicht nur die simulierte Prüfspannung auf den Eingangstrennverstärker D gegeben wird, sondern dass dieser Test 2 nur unter der Vorbedingung ablaufen kann, dass sämtliche Verbindungselemente (Spitzen, Vorwiderstände, Kabel und Eingangsstufen) funktionsgerecht arbeiten. Da aber das Einschalten und damit das Aufladen des Kondensators C1 nur durch den Test 1 (Spitze-Spitze-Durchgangsprüfung) oder durch eine Fremdspannung erfolgen kann, die von aussen an den Prüfspitzen anliegt, ist garantiert, dass der Test 2 nur dann ablaufen kann, wenn alle Verbindungselemente arbeiten (Punkt 11 und 12 der Forderungsliste).

Das Gesamtschaltbild einer bevorzugten Ausführungsform der Prüfeinrichtung der vorliegenden Erfindung ist gemäss Fig. 3 in mehrere Hauptteile A bis F unterteilt.

Die Teilschaltung A ist gemäss Fig. 4 nochmals in drei Teilschaltungen A1, A2 und A3 unterteilt.

In Fig. 3 ist der Prüfgriff 1 durch ein gestrichelt umrandetes Feld dargestellt, ebenso der Anzeigegriff 2. Beide Griffe sind durch das mit der Abschirmung 6 versehene Kabel 3 miteinander verbunden.

Zur Eingangsstufe gehören neben den Prüfspitzen 4 und 5 die beiden hochohmigen und möglichst auch spitzenspannungsfesten Vorwiderstände R30 im Prüfgriff 1 und R 0 im Anzeigegriff 2.

Der von der zu prüfenden Spannung erzeugte Strom wird durch die hochohmigen Vorwiderstände R30 und R 0 begrenzt und auf den Trennverstärker D gegeben. Dieser Trennverstärker D enthält die als Emitterfolger geschalteten Transistoren T1 und T2. Diesen Emitterfolgern wird der durch die hochohmigen Vorwiderstände R30 und R 0 begrenzte Strom über die Eingangsteilerwiderstände R1 und R2 bzw. R3 und R4 zugeführt, so dass die Transistoren T1 oder T2, je nach anliegender Polarität der Prüfspannung über den Graetz-Gleichrichter, der aus den Transistoren T1 und T2 und den Zenerdioden D1 und D2 gebildet ist, leitend werden.

Dadurch wird je nach anliegender Polarität über die Transistoren T3 bzw. T4 die Leuchtdiode LED2 für +6 V bzw. die Leuchtdiode LED1 für –6 V angesteuert und durchgeschaltet; gleichzeitig hiermit erfolgt die Einschaltung der Batterie B1, weil die Basis des Einschalttransistors T6 des Batterieteiles B dadurch, dass die Transistoren T3 oder T4 durchschalten, eine Potentialdifferenz gegen das positive Potential der Batterie B1 erhält und der Strom zum Aufleuchten der Leuchtdioden LED1 und/oder LED2, von der Batterie B1, eingeschaltet durch den Einschalttransistor T6, fliessen kann.

Der Basis des Einschalttransistors T6 sind gegenüber der Batterie B1 der Widerstand R7 und gegenüber den Leuchtdioden LED2 bzw. LED1 der Widerstand R8 vorgeschaltet.

Auch den Basen der Transistoren T3 und T4 sind Widerstände R5 und R6 vorgeschaltet.

Gesteuert durch den Trennverstärker D wird gleichzeitig mit der Durchschaltung der Transistoren T3 und/oder T4 durch den Einschalttransistor T6 der Oszillator-Transistor T5 über die Widerstände R9 und R10 eingeschaltet und die in der Induktivität L des Schaltnetzteiles A1 durch den Einschaltvorgang gespeicherte Energie gegen Masse kurzgeschlossen.

Durch den Spannungsimpuls wird die piezokeramische Biegeschwingerscheibe 10 des akustischen Signalgebers Bu (Buzzer) über die Erregerelektroden 11 und 12 zur Auslenkung gebracht. Durch das Rückfedern der piezokeramischen Biegeschwingerscheibe 10 wird über die akustische Rückkopplungselektrode 13 die Basis des Oszillatortransistors T5 wieder gesperrt.

Der Oszillator C arbeitet mit dem aktiven Vierpol (Transistor T5) nichtlinear auf die Elektroden 11 und 12 des piezokeramischen Biegeschwingers 10, und durch elektroakustische Rückkopplung wird der Oszillator C mit der Eigenfrequenz des piezokeramischen Biegeschwingers 10 mitkoppelnd betrieben, wobei die Induktivität L als Energiespeicher dient.

Ein Signalgeber der hier beschriebenen Art ist Gegenstand der DE-A1 3 013 788.

Bei Anliegen einer Eingangsspannung an den Prüfspitzen 4 und 5 im Bereich zwischen 6 V und kleiner 12 V sind die die Polarität anzeigenden Dioden LED1 und LED2 und dadurch die Batterie B1 und ferner der akustische Signalgeber Bu eingeschaltet.

Die Dioden D10 und D11 bewirken bei kleineren Eingangsspannungen eine Verminderung der Teilerverhältnisse der aus den Widerständen R1 und R2 bzw. R3 und R4 gebildeten Eingangsteiler.

Bei steigender oder höherer Eingangsspannung wird über die Emitterfolger – Transistoren T1 und T2 – und die der Erhöhung der Sperrspannung dieser Transistoren dienenden Dioden D12 und D13 ein Strom durch die Emitterfolger auf den aus den Widerständen R13, R14 und R15 gebildeten Spannungsteiler geschaltet.

Der dieser Eingangsspannung proportionale Strom erzeugt an der Basis des Transistors T10 ein Potential, das bei genügender Höhe geeignet ist, den Transistor T10 über die Konstantstromquelle T15 durchzuschalten.

Um Strom zu sparen, wird im Takt der Frequenz des Oszillators C, eingekoppelt über den Koppelkondensator C4 und in der Impulshöhe durch die Zenerdiode D4 begrenzt, ein Spannungsimpuls erzeugt, der auf die Basis der Konstantstromquelle T15 wirkt, um dort einen pulsierenden Strom konstanter Höhe zu erzeugen, der seinerseits über den jeweils eingeschalteten Transistor T10, T9 oder T8 (z.B. bei 12 V den Transistor T10) die eingeschalteten Leuchtdioden LED3, LED4 oder LED5 (z.B. bei 12 V die Leuchtdiode LED3) zum getakteten Aufleuchten bringt.

Bei noch höherer Eingangsspannung wird der Spannungsabfall am Teilerwiderstand R15 so gross, dass der Transistor T9 eingeschaltet wird, und durch die Differenzverstärkerwirkung zwischen den Transistoren T9 und T10 wird der Transistor T10 wieder abgeschaltet, so dass die Leuchtdiode LED4 eingeschaltet wird.

Die Einschaltung des Transistors T8, der – wie die Transistoren T9 und T10 – ein Transistor einer Anzeigestufe ist, erfolgt über den Widerstand R14 in der gleichen Weise, wie schon beschrieben ist, wenn die Eingangsspannung entsprechend erhöht ist.

Die Zenerdioden D1 und D2 des Graetz-Gleichrichters dienen auch der Spannungsbegrenzung.

Die Zenerdioden D5 bzw. D6 dienen dazu, bei einmal erreichter Schwellspannung an der Basis des jeweils zugehörigen Transistors (T9, T10) den Spannungsabfall mit steigender Eingangsspannung nicht weiter ansteigen zu lassen, um damit den Arbeitsbereich der Transistoren im Sinne der begrenzten Betriebsspannungsversorgung möglichst für mehrere Anzeigestufen (hier für die Anzeigestufen mit den Transistoren T8, T9 und T10) ausnutzen zu können.

Die Anzeigestufen für 12, 24 und 50 V sind zu einer Anzeigekette E zusammengefasst und werden von der Batterie B1 mit Strom versorgt.

Die Anzeigestufen für 110 V, 220 V, 380 V und 660 V sind zu einer zweiten Anzeigekette F zusammengefasst.

Diese zweite Anzeigekette F mit den Anzeigeelementen, nämlich den Leuchtdioden LED6 bis LED9, wird bei Eingangsspannungen von z.B. ab 110 V über den aus den Dioden D8 und D9 und den Zenerdioden D1 und D2 gebildeten Graetz-Gleichrichter und die durch die Zenerdiode D3 gebildete Schwellspannung eingeschaltet und arbeitet bei steigender Eingangsspannung für die angegebenen Anzeigestufen nach dem gleichen Stufenschaltprinzip, wie es bei der Anzeigekette E beschrieben ist.

Der Spannungsteiler der Anzeigekette F ist aus den Teilerwiderständen R16, R17, R18 und R19 gebildet.

Die Funktion der Zenerdiode D7 entspricht den Funktionen der Zenerdioden D5 und D6.

Die Kondensatoren C3, C5 und C6 sind Glättungskondensatoren für den Fall der Wechselspannungsprüfung.

Der Widerstand R20 ist mit dem Emitter der Konstantstromquelle T16 und mit der Basis des Transistors T14 verbunden.

Der Widerstand R21 ist der Basis der Konstantstromquelle T16 vorgeschaltet.

In der Anzeigekette F werden jedoch neben der geschalteten Konstantstromquelle T16 die miteinander verbundenen Kollektoren der Transistoren T11, T12, T13 und T14 durch den Oszillator C des Signalgebers und durch dessen überhöhte Ausgangsamplitude, die über dem Pegel der Batteriespannung liegt, betrieben, und zwar einerseits, um auch hier den Strom durch Takten (Choppen) klein zu halten, und andererseits, um eine überhöhte Spannungsversorgung zur Ansteuerung der vier Anzeigestufen dieser Anzeigekette zu erhalten.

Die Spannungsüberhöhung wird durch die zum Oszillator C gehörende Induktivität L und deren Gegeninduktivität ermöglicht. Der Oszillator C wirkt also nicht nur, zusammen mit den piezokeramischen Biegeschwinger 10, als akustischer Signalgenerator, sondern zusammen mit der Induktivität L auch als Schaltnetzteil A1 und als Chopper-Oszillator zur Energieersparnis in dem batteriebetriebenen Gerät.

Ferner wirkt der Oszillator C, eingekoppelt über den Koppelkondensator C2 über die aus den Dioden D16, D17, D19 und D20, sowie den Kondensatoren C7 und C8 bestehende Spannungsverdopplerschaltung auf den Kondensator C1 im Energiespeicher A2, in dem sich durch die Spannungserhöhung und Verdopplung eine Spannung von etwa 40 bis 50 V bildet, wenn eine 12 V Batterie eingesetzt ist. Beim Umschalten des Schaltelementes S2 vom Ruhekontakt 14 auf den Arbeitskontakt 15 lässt sich die im Energiespeicher vorhandene Spannung über die Diode D14 auf den Eingang des Trennverstärkers D schalten.

Gegebenenfalls kann der in Fig. 4 gestrichelt umrandete Widerstand R12 durch die in Fig. 5 gezeigte Teilschaltung ersetzt werden, so dass die im Energiespeicher vorhandene Spannung statt über den Widerstand R12, über den Widerstand R31 und den Trenntransistor T7, der über den Koppelkondensator C9 vom Oszillator C gechopped wird, auf den Eingang des Trennverstärkers D geschaltet wird. Es entsteht dabei eine im Takt der Frequenz des Oszillators C getaktete Eingangsspannung mit einer erhöhten Zeitkonstante.

Aus dem Energiespeicher gelangt in beiden Fällen eine Eingangsspannung, die – weil unmittelbar auf den Trennverstärker D gelegt – eine Eingangsspannung simuliert, die höher als eine an den Kontaktspitzen anliegende, zu prüfende Spannung der höchsten Anzeigestufe ist. Diese simulierte Eingangsspannung bewirkt, dass durch den mittels des Schaltelementes S2 eingeleiteten Entladevorgang die Prüfspannung von der höchsten Anzeigestufe beginnend schrittweise absinkt, so dass jede Anzeigestufe, solange der Funktionsprüfschalter des Schaltelementes S2 betätigt wird auf ihre Funktion hin überprüft werden kann, bis der Kondensator C1 entladen ist. Der akustische Signalgeber ertönt bei dieser Prüfung ebenfalls.

Die Widerstände R22 und R23 sind den Anzeigeketten E bzw. F nachgeschaltet.

Das Schaltelement S1 wird in Ruhestellung durch die Zenerdiode D18 überbrückt, so dass die Prüfeinrichtung zum Prüfen einer Spannung geschaltet ist.

Beim Umschalten des Schaltelementes S1 vom Ruhekontakt 16 auf den Arbeitskontakt 17 wird die Batterie B1 über die Schutzdiode D15 eingeschaltet. Wird zwischen den Kontaktspitzen 4 und 5 ein Leiter angeordnet, dann kann dieser auf Stromdurchgang geprüft werden.

Werden die Kontaktspitzen 4 und 5 miteinander verbunden, so erfolgt ein Eigentest, wie oben beschrieben. Auch bei diesem Eigentest wird der Energiespeicher A2 aufgeladen.

Der Widerstand R11 wird dem Kondensator C1 durch S2 parallelgeschaltet, um die Entladezeitkonstante zu erniedrigen.

Zur Verdeutlichung ist in Fig. 4 die Teilschaltung A nochmals dargestellt, und es sind bei den Eingängen bzw. Ausgängen dieser Teilschaltung Angaben darüber enthalten, mit welchen Teilen der übrigen Schaltung Verbindung besteht.

Die Wahl der in der Schaltung einzusetzenden konkreten elektrischen Bauelemente (Induktivität, Widerstände, Kondensatoren, Dioden, Zenerdioden, Transistoren, Leuchtdioden) richtet sich nach den gewünschten Bereichen für die Anzeigestufen und bereitet dem auf diesem Gebiet tätigen Fachmann bei Kenntnis der vorliegenden Erfindung keine Schwierigkeiten.

Der gestrichelt umrandete und mit dem Bezugszeichen 1 versehene Teil der Fig. 6 stellt einen der beiden Griffe der zweipoligen Prüfeinrichtung dar. Mit 2 ist der andere Griff bezeichnet, in welchem der Eingangsteilwiderstand R 0 und die Gesamtschaltung 18 der Prüfeinrichtung enthalten sind. Mit 4 ist die Prüfspitze des Griffes 1 und mit 5 ist die Prüfspitze des Griffes 2 bezeichnet. Die beiden Griffe 1 und 2 sind miteinander durch das Kabel 3, das mit einer Abschirmung 6 versehen ist, verbunden.

Ohne zugeschaltetem Lastwiderstandsteil sind der hochohmige Vorwiderstand R 0, die Gesamtschaltung 18 der Prüfeinrichtung, in der sich sämtliche Schaltelemente zur ggf. gestaffelten Anzeige der Spannung befinden, und der zweite, im Griff 1 befindliche hochohmige Vorwiderstand R30, der den anderen Teilwiderstand des hohen Eingangswiderstandes der Prüfeinrichtung darstellt, in Reihe geschaltet.

Bei Anliegen einer zu prüfenden Spannung an den Kontaktspitzen 4 und 5 und Betätigen des Tastschalters 27 wird zu der eben beschriebenen Reihenschaltung wenigstens ein PTC-Widerstand 19 parallelgeschaltet. In Reihe mit diesem PTC-Widerstand 19 ist ein Festwiderstand 23 geschaltet, durch den die Zeitkonstante des Erwärmungsvorganges beeinflusst wird.

Zur weiteren Verminderung des Lastwiderstandes sind – je nach den Erfordernissen – weitere PTC-Widerstände 20, 21 und 22 und dazu in Reihe weitere Festwiderstände 24, 25 und 26 parallelgeschaltet.

Im Diagramm nach Fig. 7 ist der Belastungsstrom in Abhängigkeit von der anliegenden Spannung und der Zeit dargestellt.

Kurve X gilt für eine anliegende Spannung von 380 V und zeigt, dass die Zeit, in der der PTC-Widerstand noch wirksam wird, in dieser beispielhaften Ausführung etwa 4 Sekunden beträgt. Hier fliesst ein Strom von 89 mA, d.h., dass bei Betätigung des Tastschalters 27 (Fig. 6) ein Widerstand von 4,2 kOhm für die Dauer von etwa 4 Sekunden eingeschaltet und damit wirksam ist. Der Widerstand von 4,2 kOhm ergibt sich z.B. durch Parallelschaltung dreier Widerstandskombinationen.

Kurve Y gilt für 220 V anliegende Spannung und zeigt, dass bei gleichem eingeschalteten Widerstand von 4,2 kOhm die Zeit der Wirksamkeit bereits 18 Sekunden dauert.

Kurve Z gilt für 110 V anliegende Spannung. Bei dieser Spannung und bei 4,2 kOhm beträgt die Zeit der Wirksamkeit schon mehr als 20 Sekunden.

Jede Spannungsquelle hat einen Innenwiderstand $R_I$, der zuweilen auch Quellwiderstand $R_Q$ genannt wird. Prüft man in Schaltkreisen Spannungen, dann ist zur Beurteilung des Messergebnisses die Kenntnis des Innenwiderstandes der Spannungsquelle von entscheidender Bedeutung. Andererseits hat jedes Messinstrument einen bestimmten Eingangswiderstand $R_E$. Die Summe von Innenwiderstand $R_I$ und Eingangswiderstand $R_E$ bestimmt den Gesamtstrom durch die sich ergebende Messanordnung, d.h. das Verhältnis von Innenwiderstand zu Eingangswiderstand bestimmt eindeutig die zu messende Spannung und kann sie verfälschen. Demnach sollte grundsätzlich der Eingangswiderstand $R_E$ eines Voltmeters oder eines Spannungsprüfgerätes (Prüfeinrichtung) so hoch wie technisch verwirklichbar sein. Nur bei sehr grossem Eingangswiderstand $R_E$ des Prüfgerätes und kleinen Innenwiderstand $R_I$ der Spannungsquelle entspricht die angezeigte Spannung auch der Spannungsquelle. Sind Eingangswiderstand und Innenwiderstand einander gleich, so wird die zu prüfende Spannung $U_O$ halbiert und es wird nur diese halbe Spannung angezeigt.

Eine direkte Aussage über den Innenwiderstand einer Spannungsquelle erhält man, wenn man den Eingangswiderstand des Prüfgerätes kleiner als den Innenwiderstand der Spannungsquelle macht. Dies ist von Vorteil, wenn man induktiv und kapazitiv eingekoppelte Spannungen prüfen will. Man erhält auf diese Weise eine Aussage, ob es sich um eine «echte» Spannungsquelle mit kleinem Innenwiderstand (Konstantspannungsquelle) handelt oder ob die Spannungsquelle einen vergleichsweise hohen Innenwiderstand hat.

Dies wird bei der vorliegenden Erfindung ausgenutzt, denn wenn die Spannungsquelle einen hohen Innenwiderstand hat, es sich also um induktiv und kapazitiv eingekoppelte Spannungen handelt, so bricht beim Zuschalten des Lastwiderstandes die Spannung zusammen.

Bei einer Prüfeinrichtung gemäss der Erfindung läuft dieser Test wie folgt ab.

Bei Prüfung der Netzspannung (220 V Wechselspannung) leuchten alle Leuchtdioden bis 220 V auf. Wird durch Betätigen des Tastschalters 27 ein Lastwiderstand parallel geschaltet, wodurch die Prüfeinrichtung niederohmig wird, so bleibt diese Anzeige erhalten, wenn es sich tatsächlich um die Netzspannung handelt.

Wenn somit bei der ersten Prüfung beispielsweise 220 V angezeigt werden und wird bei Betätigen des Tastschalters durch Zuschalten der parallel geschalteten Widerstände die angezeigte Spannung entsprechend der Höhe dieser Widerstände auf beispielsweise 24 V verringert, so folgt daraus, dass es sich um eine Spannungsquelle mit hohem Innenwiderstand und damit nicht um die Netzspannung handelt.

Durch die vorliegende Erfindung kann beispielsweise somit auch geprüft werden, ob das andere Ende einer längeren Leitung an Spannung angeschlossen ist oder nicht.

In der nachfolgend angeführten Aufstellung sind Kenndaten für einzelne Bauelemente angegeben.

Aufstellung der verwendeten Bezugszeichen und der Bauelemente mit Wertangaben (in Klammern gesetzt) als bevorzugtes Ausführungsbeispiel

| 1 | Griff mit Kontaktspitze 4 (Prüfgriff) |
|---|---|
| 2 | Griff mit Kontaktspitze 5 (Anzeigegriff) |
| 3 | Kabel |
| 4 | Kontaktspitze |
| 5 | Kontaktspitze |
| 6 | Abschirmung |
| 7 | Abrutschring |
| 8 | Abrutschring |
| 9 | Vertiefung im Anzeigegriff 2 |
| 10 | piezokeramischer Biegeschwinger |
| 11 | Elektrode |
| 12 | Elektrode |
| 13 | Rückkopplungselektrode |
| 14 | Ruhekontakt von S2 |
| 15 | Arbeitskontakt von S2 |
| 16 | Ruhekontakt von S1 |
| 17 | Arbeitskontakt von S1 |
| 18 | Gesamtschaltung im Griff 2, die aus den Teilschaltungen A bis F besteht |
| 19 | PTC-Widerstand |
| 20 | PTC-Widerstand |
| 21 | PTC-Widerstand |
| 22 | PTC-Widerstand |
| 23 | Festwiderstand |
| 24 | Festwiderstand |
| 25 | Festwiderstand |
| 26 | Festwiderstand |

| | |
|---|---|
| 27 | Tastschalter im Griff 1 |
| A | Teilschaltung |
| B | Batterieteil mit Einschaltung |
| C | Oszillator ggf. mit akustischem Signalgeber |
| D | Trennverstärker |
| E | Anzeigekette |
| F | Anzeigekette |
| G | Gehäuse für Batterie B1 |
| A1 | Schaltnetzteil |
| A2 | Energiespeicher mit Schaltelement |
| A3 | Schaltteil für Durchgangsprüfung und Eigentest |
| B1 | Batterie (12 V) |
| Bu | Signalgeber (Buzzer) |
| C1 | Kondensator im Energiespeicher A2 (22 µF/50 V) |
| C2 | Koppelkondensator (3,3 µF/50 V) |
| C3 | Glättungskondensator (1 µF/35 V) |
| C4 | Koppelkondensator (330 pF/100 V) |
| C5 | Glättungskondensator (1 µF/35 V) |
| C6 | Glättungskondensator (1,8 nF) |
| C7 | Koppelkondensator (47 nF) |
| C8 | Koppelkondensator (47 nF) |
| C9 | Koppelkondensator (wahlweise s. Fig. 5) (330 pF) |
| D1 | Zenerdiode des Graetz-Gleichrichters (51 V) |
| D2 | Zenerdiode des Greatz-Gleichrichters (51 V) |
| D3 | Zenerdiode zur Bildung einer Schwellspannung (13 V) |
| D4 | Zenerdiode zur Begrenzung der Impulshöhe (2,4 V) |
| D5 | Zenerdiode zur Begrenzung des Spannungsabfalls (5,1 V) |
| D6 | Zenerdiode zur Begrenzung des Spannungsabfalls (3,3 V) |
| D7 | Zenerdiode zur Begrenzung des Spannungsabfalls (6,8 V) |
| D8 | Diode des Graetz-Gleichrichters (1N 4148) |
| D9 | Diode des Graetz-Gleichrichters (1N 4148) |
| D10 | Diode zur Verminderung des Teilerverhältnisses von R1/R2 (1N 4148) |
| D11 | Diode zur Verminderung des Teilerverhältnisses von R3/R4 (1N 4148) |
| D12 | Diode zur Erhöhung der Sperrspannung von T1 (1N 4148) |
| D13 | Diode zur Erhöhung der Sperrspannung von T2 (1N 4148) |
| D14 | Diode nach S2/15 (1N 4148) |
| D15 | Schutzdiode vor B1 (1N 4148) |
| D16 | Diode zur Spannungsverdopplung mit D17, D19, D20 (z.B. 1N 4148) |
| D17 | Diode zur Spannungsverdopplung mit D16, D19, D20 (z.B. 1N 4148) |
| D18 | Zenerdiode des Schaltteiles A3 (24 V) |
| D19 | Zenerdiode zur Spannungsverdopplung mit D16, D19, D20 (16 V) |
| D20 | Diode zur Spannungsverdopplung mit D16, D17, D19 (1N 4148) |
| L | Induktivität im Schaltnetzteil A1 (100 mH) |

| | |
|---|---|
| LED1 | Leuchtdiode für 6 V und negative Polarität (z.B. Siemens CQV 10-5/LD 30 II) |
| LED2 | Leuchtdiode für 6 V und positive Polarität (z.B. Siemens CQV 10-5/LD 30 II) |
| LED3 | Leuchtdiode für 12 V (z.B. Siemens CQV 10-5/LD 30 II) |
| LED4 | Leuchtdiode für 24 V (z.B. Siemens CQV 10-5/LD 30 II) |
| LED5 | Leuchtdiode für 50 V (z.B. Siemens CQV 10-5/LD 30 II) |
| LED6 | Leuchtdiode für 110 V (z.B. Siemens CQV 10-5/LD 30 II) |
| LED7 | Leuchtdiode für 220 V (z.B. Siemens CQV 10-5/LD 30 II) |
| LED8 | Leuchtdiode für 380 V (z.B. Siemens CQV 10-5/LD 30 II) |
| LED9 | Leuchtdiode für 660 V (z.B. Siemens CQV 10-5/LD 30 II) |
| R 0 | hochohmiger Vorwiderstand (330 kOhm) |
| R1 | Eingangsteilerwiderstand (100 kOhm) |
| R2 | Eingangsteilerwiderstand (180 kOhm) |
| R3 | Eingangsteilerwiderstand (100 kOhm) |
| R4 | Eingangsteilerwiderstand (180 kOhm) |
| R5 | Widerstand vor T3 (47 kOhm) |
| R6 | Widerstand vor T4 (47 kOhm) |
| R7 | Widerstand vor T6 (100 kOhm) |
| R8 | Widerstand vor T6 (3,9 kOhm) |
| R9 | Widerstand vor R10 des Oszillators C (150 kOhm) |
| R10 | Widerstand vor T5 des Oszillators C (15 kOhm) |
| R11 | Widerstand (150 kOhm) |
| R12 | Widerstand (wahlweise s. Fig. 4) (5,6 kOhm) |
| R13 | Teilerwiderstand der Anzeigestufe (50 V (6,8 kOhm) |
| R14 | Teilerwiderstand der Anzeigestufe 24 V (8,2 kOhm) |
| R15 | Teilerwiderstand der Anzeigestufe 12 V (100 kOhm) |
| R16 | Teilerwiderstand der Anzeigestufe 660 V (6,8 kOhm) |
| R17 | Teilerwiderstand der Anzeigestufe 380 V (2,4 kOhm) |
| R18 | Teilerwiderstand der Anzeigestufe 220 V (5,1 kOhm) |
| R19 | Teilerwiderstand der Anzeigestufe 110 V (10 kOhm) |
| R20 | Widerstand zwischen T14 und T16 (15 kOhm) |
| R21 | Widerstand vor T16 (7,5 kOhm) |
| R22 | Vorwiderstand (51 Ohm) |
| R23 | Vorwiderstand (68 Ohm) |
| R30 | hochohmiger Vorwiderstand (330 kOhm) |
| R31 | Widerstand (wahlweise s. Fig. 5) (100 kOhm) |
| S1 | Schaltelement |
| S2 | Schaltelement |
| T1 | Transistor des Emitterfolgers im Trennverstärker (BC 237) |
| T2 | Transistor des Emitterfolgers im Trennverstärker (BC 237) |
| T3 | Transistor für LED2 (BC 237) |

| T4 | Transistor für LED1 (BC 237) |
|---|---|
| T5 | Oszillatortransistor (BC 546) |
| T6 | Einschalttransistor im Batterieteil B (BC 556) |
| T7 | Trenntransistor (wahlweise s. Fig. 5) (BC 556) |
| T8 | Transistor der Anzeigestufe 50 V (BC237) |
| T9 | Transistor der Anzeigestufe 24 V (BC 237) |
| T10 | Transistor der Anzeigestufe 12 V (BC 237) |
| T11 | Transistor der Anzeigestufe 660 V (BC 546) |
| T12 | Transistor der Anzeigestufe 380 V (BC 546) |
| T13 | Transistor der Anzeigestufe 220 V (BC 546) |
| T14 | Transistor der Anzeigestufe 110 V (BC 546) |
| T15 | Konstantstromquelle für E (BC 237) |
| T16 | Konstantstromquelle für F (BC 237) |
| X | Kurve für 380 V |
| Y | Kurve für 220 V |
| Z | Kurve für 110 V |

**Patentansprüche**

1. Prüfeinrichtung zum Anzeigen einer elektrischen Spannung, deren Polarität und zur Durchgangsprüfung, die aus zwei durch ein Kabel (3) verbundenen, mit Kontaktspitzen (4, 5) versehenen und je einen den Kontaktspitzen (4, 5) nachgeschalteten hochohmigen Vorwiderstand (R30, R 0) enthaltenden Griffen (1, 2) besteht und einer dieser Griffe (2) optische Anzeigeelemente (LED1 bis 9) von in Spannungsbereiche (z.B. 6, 12, 24, 50, 110, 220, 380, 660 Volt) gestaffelten Anzeigestufen, einen Oszillator (C) der einen gegebenenfalls vorhandenen akustischen Signalgeber (Bu) ansteuern kann, und einen Trennverstärker (D) enthält, der den durch die beiden Vorwiderstände (R30, R 0) begrenzten Eingangsstrom verstärkt, eine in der Prüfeinrichtung vorhandene Batterie (B1) in den Stromkreis einschaltet und damit die gestaffelte Anzeige der zu prüfenden Spannung und gegebenenfalls die Anzeige deren Polarität sowie die Einschaltung des akustischen Signalgebers bewirkt, gekennzeichnet durch folgende Merkmale
a) es ist ein Schaltnetzteil (A1) vorhanden, das durch den Oszillator (C) gespeist wird und zur Überhöhung, durch die Batterie (B1) begrenzten Oszillatorspannung dient,
b) es ist ein Energiespeicher (A2) vorhanden, insbesondere in Form eines Kondensators (C1), der durch die Ausgangsspannung des Schaltnetzteiles (A1) gespeist wird, solange ein zwischengeschaltetes Schaltelement (S2) sich in Ruhestellung befindet,
c) das bei der Aufladung des Energiespeichers (A2) in Ruhestellung befindliche Schaltelement (S2) ist umschaltbar, um die im Energiespeicher (A2) befindliche Ladung auf den Eingang des Trennverstärkers (D) zu legen und damit die Funktionsfähigkeit sämtlicher Anzeigefunktionen der Prüfeinrichtung der Reihe nach selbsttätig zu überprüfen,
d) der Oszillator (C) ist mit der Basis von Transistoren (T15, T16, Fig. 3) verbunden, die den Anzeigestrom für die Anzeigeelemente (LED6 bis LED9) sowohl für zu prüfende Spannungen in oberen Spannungsbereichen (gleich oder grösser 110 V) als auch für die Anzeigeelemente (LED3 bis LED5) für zu prüfende Spannungen unterer Spannungsbereiche (grösser 6 und bis kleiner 110 V) kurzzeitig intermittierend einschalten (choppen),
e) es ist ein Schaltelement (S1) vorhanden, das in Ruhestellung eine Zenerdiode (D18) überbrückt und bei dessen Umschaltung auf den Arbeitskontakt durch Einschalten der Batterie (B1) die Durchgangsprüfung durch einen zwischen den Kontaktspitzen (4 und 5) befindlichen Leiter oder beim unmittelbaren Kontakt zwischen den Kontaktspitzen (4, 5) der Eigentest der Prüfeinrichtung auf Funktionsfähigkeit der Batterie (B1), des Signalgebers (Bu), der Anzeigeelemente (LED1 und LED2) für die Polaritätsanzeige und, je nach Batteriespannung, des zugehörigen weiteren Anzeigeelementes (LED3) sowie die Aufladung des Kondensators (C1) im Energiespeicher (A2) erfolgt.

2. Prüfeinrichtung nach Anspruch 1, gekennzeichnet durch folgende Merkmale
a) dem als Eingangsstufe dienenden Trennverstärker (D) sind die beiden hochohmigen, spannungsfesten Vorwiderstände vorgeschaltet, von denen einer (R 0) im Griff (2) und der andere (R30), getrennt über das mit der Abschirmung (6) versehene Kabel (3), im anderen Griff (1) untergebracht sind, wobei diese beiden Vorwiderstände (R 0, R30) den durch die zu prüfende Spannung erzeugten Strom begrenzen, der dem Trennverstärker (D), enthaltend die Emitterfolger (Transistoren T1 und T2) und die Eingangsteiler (Widerstände R1 und R2 bzw. R3 und R4), zugeführt wird, so dass die Transistoren (T1 oder T2) je nach dem Anliegen der Polarität der zu prüfenden Spannung über einen Graetz-Gleichrichter, der aus den Transistoren (T1 und T2) und den Zenerdioden (D1 und D2) gebildet ist, leitend werden und damit je nach Anliegen der Polarität über die Transistoren (T3 und T4) entweder die Leuchtdiode (LED2) für die Anzeige der positiven Eingangsspannung oder die Leuchtdiode (LED1) für die Anzeige der negativen Eingangsspannung oder bei Wechselspannung beide Leuchtdioden (LED1 und LED2) angesteuert und durchgeschaltet werden und gleichzeitig, indem die Transistoren (T3 und T4) durchschalten, die Basis des Transistors (T6) eine Potentialdifferenz zum positiven Potential der Batterie (B1) erhält und der Strom zum Aufleuchten der Anzeigeelemente (LED1 und/oder LED2), eingeschaltet durch den Transistor (T6), fliessen kann,
b) der Oszillator (C) besteht aus einer Zusammenschaltung eines Transistors (T5), Widerständen (R9 und R10), einer Induktivität (L) und dem Signalgeber (Bu), der in an sich bekannter Weise aus einem piezokeramischen Schwinger (10) mit drei Elektroden (11, 12, 13) besteht und durch den Oszillator-Transistor (T5) über die Widerstände (R9 und R10) eingeschaltet wird,

c) das Schaltnetzteil (A1) besteht aus vier Dioden (D16, D17, D19 und D20), drei Koppelkondensatoren (C2, C3 und C8) und der zugeschalteten Induktivität (L) und wird über den Oszillator (C) angesteuert,

d) der Energiespeicher (A2) besteht aus einem Speicherkondensator (C1), einer der Spitzengleichrichtung dienenden Diode (D17) und einem Schaltelement (S2), über dessen Ruhestellung Speicherkondensator (C1) und Diode (D17) miteinander verbunden sind, wobei die Spannungsimpulse aus dem Schaltnetzteil (A1) durch die Spitzengleichrichtung (Diode D17) im Speicherkondensator (C1) gespeichert werden, so dass dieser sich auf den Scheitelwert der Spannungsimpulse auflädt,

e) in der Verbindung zwischen dem Arbeitskontakt des Schalters (S2) und dem Eingang zum Trennverstärker (D) befindet sich eine Schutzdiode (D14) und ein Strombegrenzungswiderstand (R12).

3. Prüfeinrichtung nach Anspruch 1 oder 2, dadurch gekennzeichnet, dass die Anzeigestufen für die gestaffelte Anzeige der einzelnen Spannungsbereiche in zwei Anzeigeketten (E, F) geteilt ist, die getrennt voneinander mit dem Anzeigestrom versorgt werden, dass eine Anzeigekette (E) für untere Spannungsbereiche (grösser 6 bis kleiner 110 V) aus der Batterie (B1) über den Schalttransistor (T6) gespeist wird, dass die andere Anzeigekette (F) für obere Spannungsbereiche (gleich oder grösser 110 V) aus dem Schaltnetzteil (A1) gespeist wird und dass beide Anzeigeketten (E, F) zur Stromeinsparung mit der Frequenz des Oszillators (C) intermittierend geschaltet (gechoppt) werden.

4. Prüfeinrichtung nach Anspruch 2 oder 3, dadurch gekennzeichnet, dass der Strombegrenzungswiderstand (R12) zwischen dem Arbeitskontakt (15) des Schalters (S2) und der Schutzdiode (D14) durch eine Schaltungsanordnung (Fig. 5) aus einem Widerstand (R31), einem Trenntransistor (T7) und einem Koppelkondensator (C9) ersetzt ist, wobei der Emitter des Trenntransistors (T7) mit der Diode (D14), sein Kollektor und der eine Kontakt des Widerstandes (R31) mit dem Arbeitskontakt (15), die Basis des Trenntransistors (T7) mit dem anderen Kontakt des Widerstandes (R31) und beide mit einem Pol des Koppelkondensators (C9) verbunden sind (Fig. 5).

5. Prüfeinrichtung nach einem der Ansprüche 1 bis 4 mit einer Schaltungsanordnung zur vorübergehenden Erniedrigung ihres hohen (≧600 kOhm) Eingangswiderstandes, dadurch gekennzeichnet, dass der Gesamtschaltung (18) im Griff 2 und den den hohen Eingangswiderstand ergebenden, in den Griffen (2 und 1) untergebrachten Widerständen (R 0 und R30) wenigstens ein PTC-Widerstand (19, 20, 21, 22) mit einem Nennwiderstand $R_N$ im Bereich zwischen 200 Ohm und 5 kOhm wahlweise einschaltbar parallel geschaltet ist, der eine Zeitkonstante der Eigenerwärmung (Betriebsschaltzeit $t_{aB}$) von wenigstens einer Sekunde gewährleistet (Fig. 6).

6. Prüfeinrichtung nach Anspruch 5, dadurch gekennzeichnet, dass mit jedem PTC-Widerstand (19, 20, 21, 22) ein Widerstand (23, 24, 25, 26) mit praktisch festem Widerstandswert in Reihe geschaltet ist (Fig. 6).

7. Prüfeinrichtung nach Anspruch 5 oder 6, dadurch gekennzeichnet, dass bei einem Eingangswiderstand (R 0 + R30) der Prüfeinrichtung von 660 kOhm der hinzuschaltbare PTC-Widerstand (19, 20, 21, 22) einen Nennwiderstandswert im Bereich von 200 Ohm bis 5 kOhm aufweist.

8. Prüfeinrichtung nach Anspruch 7, dadurch gekennzeichnet, dass der wenigstens eine Festwiderstand (23, 24, 25, 26) einen Widerstandswert im Bereich zwischen 1 kOhm und 15 kOhm aufweist.

## Claims

1. A test device for displaying an electrical voltage and the polarity thereof, and for continuity testing, having two handles (1, 2) provided with contact tips (4, 5), connected by a cable (3), each containing a high value series resistor (R30, R 0) connected to its contact tip (4, 5), one handle (2) containing optical display elements (LED1 to 9) forming display stages in staggered voltage ranges (e.g. 6, 12, 24, 50, 110, 220, 380, 660 volts), an oscillator (C) capable of driving an acoustic signal generator (Bu) and an isolating amplifier (D) which amplifies the input current limited by the two series resistors (R30, R 0) to connect into circuit a battery (B1) contained in the test device, and thus effect a graduated display of the voltage which is to be tested, and possibly of the polarity thereof, and likewise switches on the acoustic signal generator, characterised by the following features:

(a) a switching network component (A1) fed by the oscillator (C) to raise the oscillator voltage that is otherwise limited by the battery (B1);

(b) an energy store (A2), in particular in the form of a capacitor (C1), fed by the output voltage of the switching network component (A1) for such time as an interposed switching element (S2) occupies the rest position;

(c) the switching element (S2), which occupies the rest position during the charging of the energy store (A2), having switch-over facilities to feed the charge contained in the energy store (A2) to the input of the isolating amplifier (D), and thus to automatically test the functioning efficiency of all the display functions of the test device in turn;

(d) the connection of the oscillator (C) to the base of transistors (T15, T16) (Fig. 3) which temporarily and intermittently connect (chop) the display current for the display elements (LED6 to LED9) both for voltages to be tested in upper voltage ranges (equal to or greater than 110 V) and for the display elements (LED3 to LED5) for voltages to be tested in lower voltage ranges (exceeding 6 but less than 110 V); and

(e) a switching element (S1) which bridges a Zener diode (D18) when in the rest position, and when switched-over to make contact as a result of the switching-on of the battery (B1) performs a conductivity test through a conductor located between the contact tips (4 and 5), or in the event of a direct contact between the contact tips (4, 5), causes self-testing of the test device to establish the functioning efficiency of the battery (B1), the signal generator (Bu), the display elements (LED1 and LED2) for the polarity display, and – in accordance with the battery voltage, of the associated further display element (LED3), and likewise the charging of the capacitor (C1) in the energy store (A2).

2. A test device as claimed in Claim 1, characterised by the following features:

(a) the isolating amplifier (D) input stage is preceded by the two high voltage-limiting series resistors, of which one (R 0) is accommodated in the handle (2) and the other (R30) is accommodated in the other handle (1), separated via the cable (3) provided with the screening (6), where these two series resistors (R 0, R30) limit the current generated by the voltage to be tested which is fed to the isolating amplifier (D) containing the emitter followers (transistors T1 and T2), and the input dividers (resistors R1, R2 and R3, R4), so that the transistors (T1 or T2) become conductive depending upon the connection of the polarity of the voltage to be tested via a bridge rectifier which consists of the transistors (T1 and T2) and Zener diodes (D1 and D2), and thus, depending upon the connection of the polarity via the transistors (T3 and T4), either the luminescence diode (LED2) for the display of the positive input voltage or the luminescence diode (LED1) for the display of the negative input voltage – or in the event of an alternating voltage both luminescence diodes (LED1 and LED2) – are driven conductive, and simultaneously, in that the transistors (T3 and T4) are switched through, the base of the transistor (T6) acquires a potential difference to the positive potential of the battery (B1), and permits flow of the current to eliminate the display elements (LED1 and /or LED2) switched on by the transistor (T6);
(b) the oscillator (C) consists of an interconnection of a transistor (T5), resistors (R9 and R10), an inductance (L) and the signal generator (bu) which is formed in known manner by a piezo-ceramic oscillator (10) with three electrodes (11, 12, 13) and is switched on by the oscillator transistor (T5) via the resistors (R9 and R10);
(c) the switching network component (A1) consists of four diodes (D16, D17, D19 and D20), three coupling capacitors (C2, C3 and C8) and the connected inductance (L), and is driven via the oscillator (C);
(d) the energy store (A2) consists of a store capacitor (C1), a diode (D17) which serves for peak rectification, and a switching element (S2) via whose rest position the storage capacitor (C1) and the diode (D17) are connected to one another, where the voltage pulses from the switching network component (A1) are stored by the peak rectification (diode D17) in the storage capacitor (C1), so that the latter is charged to the peak value of the voltage pulses; and
(e) a protective diode (D14) and a current limiting resistor (R12) are arranged in the link between the make contact of the switch (S2) and the input to the isolating amplifier (D).

3. A test device as claimed in Claim 1 or 2, characterised in that the display stages for the graduated display of the individual voltage ranges is divided into two display chains (E, F) separately supplied with the display current, that a display chain (E) for lower voltage ranges (exceeding 6 but less than 110 V) is fed from the battery (B1) via the switching transistor (T6), that the other display chain (F) for upper voltage ranges (equal to or greater than 110 V) is fed from the switching network component (A1), and that the two display chains (E, F) are intermittently connected (chopped) with the frequency of the oscillator (C) for current economy.

4. A test device as claimed in Claim 2 or 3, characterised in that the current limiting resistor (R12) between the make contact (15) of the switch (S2) and the protective diode (D14) is replaced by a circuit arrangement (Fig. 5) consisting of a resistor (R31), an isolating transistor (T7), and a coupling capacitor (C9), where the emitter of the isolating transistor (T7) is connected to the diode (D14), its collector and the first contact of the resistor (R31) are connected to the make contact (15), the base of the isolating transistor (T7) is connected to the other contact of the resistor (R31), and both are connected to one pole of the coupling capacitor (C9) (Fig. 5).

5. A test device as claimed in one of the Claims 1 to 4, with a circuit arrangement for temporarily reducing its high input resistance ($\geqq$600 kOhm), characterised in that the entire circuit (18) in the handle (2) and the resistors (R 0 and R30) accommodated in the handles (2 and 1) to produce the high input resistance are connected in parallel to at least one PTC-resistor (19, 20, 21, 22) having a nominal resistance $R_N$ in the range between 200 Ohms and 5 kOhms so as to be selectively connectible, where said PTC-resistor ensures a time constant of the self-heating (operating switching time $t_{aB}$) of at least one second (Fig. 6).

6. A test device as claimed in Claim 5, characterised in that each PTC-resistor (19, 20, 21, 22) is connected in series with a resistor (23, 24, 25, 26) having a virtually fixed resistance value (Fig. 6).

7. A test device as claimed in Claim 5 or 6, characterised in that where the test device has an input resistance (R 0 + R30) of 660 kOhm, the PTC-resistor (19, 20, 21, 22) which can be connected in addition thereto possesses a nominal resistance in the range from 200 Ohms to 5 kOhms.

8. A test device as claimed in Claim 7, characterised in that the minimum of one fixed resistor (23, 24, 25, 26) has a resistance value in the range between 1 kOhm and 15 kOhms.

## Revendications

1. Dispositif de contrôle pour l'affichage d'une tension électrique et de sa polarité et pour le contrôle de continuité, qui est constitué par deux poignées (1, 2), reliées par un câble (3) et munies de pointes de contact (4, 5) et contenant des résistances additionnelles respectives (R30, R 0) de forte valeur ohmique, branchées en aval des pointes de contact (4, 5), l'une de ces poignées (2) comportant des éléments d'affichage optique (LED1 à 9) de paliers d'affichage échelonnés pour des plages de tensions (par exemple 6, 12, 24, 50, 110, 220, 380, 660 volts), un oscillateur (C) qui peut commander un générateur de signaux acoustiques (Bu) éventuellement présent, et qui comporte un amplificateur de séparation (D), qui amplifie le courant d'entrée limité par les deux résistances additionnelles (R30, R 0), qui branche dans le circuit une pile (D1) présente dans le dispositif de contrôle et réalise par conséquent l'affichage échelonné de la tension à contrôler et éventuellement l'affichage de sa polarité ainsi que le branchement du générateur de signaux acoustiques, caractérisé par les caractéristiques suivantes:

a) il est prévu un bloc d'alimentation (A) qui est alimenté par l'oscillateur (C) et qui sert à accroître la tension de l'oscillateur limitée par la pile (B1),
b) il est prévu un accumulateur d'énergie (A2), en particulier sous la forme d'un condensateur (C1), qui est alimenté par la tension de sortie du bloc d'alimentation (A1) tant qu'un organe de commutation (S2) intercalé est situé à l'état de repos,
c) l'organe de commutation (S2) qui est situé dans la position de repos lors de la charge de l'accumulateur d'énergie (A2) est commutable de manière à appliquer la charge située dans l'accumulateur d'énergie (A2) à l'entrée de l'amplificateur de séparation (D) et à contrôler successivement de façon automatique l'aptitude au fonctionnement de toutes les fonctions d'affichage du dispositif de contrôle,
d) l'oscillateur (C) est relié à la base de transistors (T15, T16, fig. 2), qui branchent de façon intermittente pendant de brefs intervalles de temps (hachent) le courant d'affichage pour les éléments d'affichage (LED6 à LED9) ainsi que pour les tensions à contrôler dans les plages supérieures de tensions (égales ou supérieures à 110 V) ainsi que pour les éléments d'affichage (LED3 à LED5) pour des tensions à contrôler de plages de tensions inférieures (supérieures à 6 et jusqu'à moins de 110 V),
e) il est prévu un organe de commutation (S1) qui, dans sa position de repos, shunte une diode Zener (D 18), et lors de la commutation de cet organe de commutation sur son contact de travail, le contrôle de continuité est effectué à l'aide d'un conducteur situé entre les pointes de contact (4 et 5), par suite du branchement de la pile (B1), ou dans le cas du contact direct entre les pointes de contact (4, 5), le test d'auto-fonctionnement du dispositif de contrôle concernant l'aptitude du fonctionnement de la pile (B1), du générateur de signaux (Bu), des éléments d'affichage (LED1 à LED2) pour l'affichage de la polarité et, selon la tension de la pile, de l'autre élément d'affichage associé (LED3) ainsi que la charge du condensateur (C1) dans l'accumulateur d'énergie (A2) est effectué.

2. Dispositif de contrôle suivant la revendication 1, caractérisé par les moyens suivants:

a) en amont de l'amplificateur de séparation (D) servant d'étage d'entrée sont branchées les deux résistances additionnelles de forte valeur ohmique, résistant à la tension et dont l'une (R 0) est montée dans la poignée (2) et dont l'autre (R30) est montée, en étant séparée par l'intermédiaire du câble (3) muni du blindage (6), dans l'autre poignée (1), ces deux résistances additionnelles (R 0, R30) limitant le courant produit par la tension devant être contrôlée et qui est envoyé à l'amplificateur de séparation (D), contenant les émetteurs suiveurs (transistors T1 et T2) et les diviseurs d'entrée (résistances R1 et R2 ou R3 et R4), de sorte que les transistors (T1 ou T2) deviennent conducteurs respectivement après l'application de la polarité de la tension à contrôler, par l'intermédiaire d'un redresseur de Graetz, qui est formé par les transistors (T1 et T2) et par les diodes Zener (D1 et D2), et que de ce fait, par suite de l'application de la polarité par l'intermédiaire des transistors (T3 et T4), soit la diode à luminescence (LED2) servant à l'affichage de la tension d'entrée positive, soit la diode à luminescence (LED1) pour l'affichage de la tension d'entrée négative ou, dans le cas d'une tension alternative, les deux diodes à luminescence (LED1 et LED2) sont commandées et interconnectées directement et que simultanément, étant donné que les transistors (T3 et T4) sont placés à l'état conducteur, que la base du transistor (T6) reçoit une différence de potentiel par rapport au potentiel positif de la pile (B1), et le courant peut circuler pour éclairer les éléments d'affichage (LED1 et/ou LED2) branchés par le transistor (T6),
b) l'oscillateur (C) est constitué par l'interconnexion d'un transistor (T5), de résistances (R9 et R10), d'une inductance (L) et du générateur de signaux (Bu), qui est constitué de façon connue en soi par un transducteur piézo-céramique (10) comportant trois électrodes (11, 12, 13) et est branché par le transistor (T5) de l'oscillateur par l'intermédiaire des résistances (R9 et R10),
c) le bloc d'alimentation (A1) est constitué par quatre diodes (D16, D19 et D20), par trois condensateurs de couplage (C2, C3 et C8) et par l'inductance (L) branchée en supplément et est commandé par l'intermédiaire de l'oscillateur (C),
d) l'accumulateur d'énergie (A2) est constitué par un condensateur de stockage (C), par une diode (D17) servant au redressement des pointes et par un organe de commutation (S2), dont la position de repos permet d'établir la liaison entre le condensateur de stockage (C1) et la diode (D17), les impulsions de tension délivrées par le bloc d'alimentation (A1) étant stockées par l'intermédiaire du dispositif de redressement des valeurs crêtes (diode D17) dans le condensateur de stockage (C1), si bien que ce dernier se charge à la valeur crête des impulsions de tension,
e) une diode de protection (D14) et une résistance (R12) de limitation du courant sont situées dans la liaison entre le contact de travail du commutateur (S2) et l'entrée de l'amplificateur de séparation (D).

3. Dispositif de contrôle suivant la revendication 1 ou 2, caractérisé par le fait que les paliers d'affichage servant à l'affichage échelonné des différentes plages de tensions sont subdivisés en deux chaînes d'affichage (E, F), qui sont alimentées séparément l'une de l'autre par le courant d'affichage, une chaîne d'affichage (E) pour des plages inférieures de tensions (supérieures à 6 et jusqu'à moins de 110 V) est alimentée à partir de la pile (B) par l'intermédiaire du transistor de commutation (T6), que l'autre chaîne d'affichage (F) pour les plages supérieures de tensions (égales ou supérieures à 110 V) est alimentée à partir du bloc d'alimentation (A1) et que les deux chaînes d'affichage (E, F) sont branchées de façon intermittente (de façon hachée) pour réaliser l'alimentation en courant à la fréquence de l'oscillateur (C).

4. Dispositif de contrôle suivant la revendication 2 ou 3, caractérisé par le fait que la résistance (R12) de limitation du courant située entre le contact de travail (15) du commutateur (S2) ou la diode protection (D14) est remplacée par un montage (fig. 5) constitué par une résistance (R31), par un transistor de séparation (S7) et par un condensateur de couplage (C9), l'émetteur du transistor de séparation (T7) étant relié à la diode (D14), son collecteur et un contact de la résistance (R31) étant reliés au contact de travail (15), la base du transistor de séparation (S1) étant reliée à l'autre contact de la résistance (R31) et cette base et ce contact étant reliés à un pôle du condensateur de couplage (C9, fig. 5).

5. Dispositif de contrôle suivant l'une des revendications 1 à 4, comportant un montage servant à réduire de façon transitoire sa résistance d'entrée élevée ($\geqq$600 kOhms), caractérisé par le fait qu'en parallèle avec l'ensemble du circuit (18) situé dans la poignée (2) et les résistances (R 0 et R30) formant la résistance d'entrées élevée et logée dans les poignées (2 et 1), est branché, de manière à pouvoir être interconnectée au choix, une résistance à coefficient positif de température (19, 21, 22) possédant une valeur résistive nominale $R_N$ située dans la plage entre 200 ohms et 5 kOhms et qui garantit une constante de temps de l'échauffement propre (durée de commutation de fonctionnement $t_{aB}$ d'au moins une seconde (fig. 6).

6. Dispositif de contrôle suivant la revendication 5, caractérisé par le fait qu'avec chaque résistance à coefficient positif de température (19, 20, 21, 22) se trouve branchée en série une résistance (23, 24, 25, 26) possédant une valeur résistive pratiquement fixe (fig. 6).

7. Dispositif de contrôle suivant la revendication 5 ou 6, caractérisé par le fait que dans le cas d'une résistance d'entrée (R 0 plus R30) du dispositif de contrôle d'une valeur de 660 kOhms, la résistance à coefficient positif de température (19, 20, 21, 22) pouvant être branchée en supplément possède une valeur résistive nominale située dans la plage allant de 200 ohms à 5 kOhms.

8. Dispositif de contrôle suivant la revendication 7, caractérisé par le fait qu'au moins une résistance fixe (23, 24, 25, 26) possède une valeur résistive située dans la plage comprise entre 1 kOhms et 15 kOhms.

FIG 1

**FIG 2**

**FIG 4**

**FIG 5**

FIG 3

# FIG 6

# FIG 7